# Europäisches Patentamt
## European Patent Office
## Office européen des brevets

(19)

(11) Veröffentlichungsnummer: **0 033 155**
**B1**

(12) ## EUROPÄISCHE PATENTSCHRIFT

(45) Veröffentlichungstag der Patentschrift:
**21.09.83**

(51) Int. Cl.³: **H 01 C 17/06, H 01 L 21/28**

(21) Anmeldenummer: **81100555.2**

(22) Anmeldetag: **26.01.81**

(54) Verfahren zum Herstellen von thermisch und elektrisch stabilen, metallischen Schichten.

(30) Priorität: **29.01.80 DE 3003136**

(43) Veröffentlichungstag der Anmeldung:
**05.08.81 Patentblatt 81/31**

(45) Bekanntmachung des Hinweises auf die Patenterteilung:
**21.09.83 Patentblatt 83/38**

(84) Benannte Vertragsstaaten:
**CH FR GB IT LI NL**

(56) Entgegenhaltungen:
**DE-A-1 446 283**
**DE-A-2 126 182**
**DE-A-2 727 659**
**DE-A-2 821 196**
**DE-B-1 465 701**
**GB-A-1 220 964**

(73) Patentinhaber: **SIEMENS AKTIENGESELLSCHAFT,**
**Berlin und München Wittelsbacherplatz 2,**
**D-8000 München 2 (DE)**

(72) Erfinder: **Hieber, Konrad, Dr., Aiblingerstrasse 3,**
**D-8000 München 19 (DE)**
Erfinder: **Mayer, Norbert, Dr., Höglwörtherstrasse 216,**
**D-8000 München 70 (DE)**

ACTORUM AG

Verfahren zum Herstellen von thermisch und elektrisch stabilen, metallischen Schichten

Die vorliegende Patentanmeldung betrifft ein Verfahren zum Herstellen von thermisch und elektrisch stabilen, metallischen Schichten auf Substraten, wie sie insbesondere in der Halbleiter- und Dünnschichttechnologie Anwendung finden, bei dem die Metallschichten bei höchstens Raumtemperatur auf den Substraten niedergeschlagen werden und im Anschluss daran oder nach Fertigstellung der Bauelementstruktur einer thermischen Belastung oberhalb ihrer Kristallisations- bzw. Rekristallisationstemperatur ausgesetzt werden. Ein derartiges Verfahren ist aus der GB-A Nr. 1220964 bekannt.

In der Dünnschicht-Technik werden metallische Schichten u.a. als Widerstände, Elektroden für Kondensatoren, Induktivitäten und Leiterbahnen verwendet. Dabei wird als Substratmaterial Keramig, Glas, Quarz und Silizium mit und ohne $SiO_2$-Schicht sowie Kunststoffolien verwendet.

Für die Herstellung der Schichten kommen die unterschiedlichsten Verfahren, wie z.B. die galvanische Abscheidung, Aufdampfen oder Aufstäuben zum Einsatz. Allen Methoden der Schichtgewinnung ist gemeinsam, dass das Material im Vergleich zu seinem Schmelzpunkt bei niedrigen Temperaturen und in Anwesenheit von Fremdatomen abgeschieden wird. Dadurch besitzen die metallischen Schichten eine hohe Dichte an Kristallbaufehlern und einen im Vergleich zum entsprechenden Massivmaterial erhöhten spezifischen elektrischen Widerstand. Da diese Kristallbaufehler ausheilen, wenn das Material z.B. im Dauerbetrieb des Bauelementes längere Zeit bei erhöhter Temperatur (z.B. 120° C) lagert, kommt es zu unerwünschten, irreversible Änderungen der elektrischen Eigenschaften.

Um eine effektive Voralterung zu erreichen, müssten die Bauteile längere Zeit bei erhöhter Temperatur gelagert werden. Dies ist jedoch nicht möglich, da dadurch unerwünschte Reaktionen zwischen den verschiedenen Materialien einsetzen bzw. Dotierungsprofile im Halbleiterkörper verändert werden.

Damit Alterungseffekte nicht zu einem Ausfall von Bauelementen führen, werden für deren Einsatz u.a. maximale Betriebstemperaturen und Stromdichten vorgeschrieben.

Bekannterweise werden bei der Herstellung des Bauelementes die metallischen Schichten bei einer möglichst hohen Temperatur (typisch 150° C) abgeschieden und nachträglich getempert (typisch 30 min bei 350° C), um eine gewisse Voralterung zu erreichen.

Des weiteren ist bekannt, bei der Auswahl der Metalle solchen Materialien den Vorzug zu geben, deren Gitterfehler erst bei relativ hohen Temperaturen ausheilen (z.B. Metalle mit hohem Schmelzpunkt). Ferner werden den Metallen auch bestimmte Zusätze beilegiert, um das Gefüge zu stabilisieren (z.B. 1% Silizium oder Kupfer in Aluminium).

Alle diese Verfahren stellen nur Kompromisslösungen dar und vermögen nicht, das Problem der elektrischen Stabilität von metallischen Schichten, insbesondere bei ihrer Anwendung in Dünnschichtschaltungen, befriedigend zu lösen.

Aus der GB-A Nr. 1220964 ist ein Verfahren zum Herstellen von thermisch stabilen, metallischen Schichten auf Substraten bekannt, bei dem die Metallschichten bei höchstens Raumtemperatur auf den Substraten niedergeschlagen werden und im Anschluss daran einer thermischen Belastung ausgesetzt werden.

Ein Verfahren, bei dem metallische Schichten erhalten werden, ohne dass Temperaturen über 350° C erforderlich sind, ist aus der DE-A Nr. 2727659 bekannt. Bei diesem Verfahren werden stabile Schichteigenschaften dadurch erzielt, dass die vorzugsweise aus Tantal bestehenden Metallschichten bei tiefer Substrattemperatur in amorpher bzw. stark gestörter Form, z.B. bei −160° C, auf dem Substrat niedergeschlagen werden und anschliessend durch vergleichsweise geringe Erwärmung des Substrats zur Kristallisation gebracht werden. Auf diese Weise werden kohärente Gitterbereiche von kleiner 4 µm bei Erwärmen des Substrats über ca. −90° C auf Kristalle mit einem Korndurchmesser von mindestens 70 µm vergrössert. Diese Schichten behalten auch bei sehr viel höheren Temperaturen (höher als 400° C) ihre Eigenschaften bei, obwohl sie beim Herstellvorgang keiner höheren Temperatur als −90° C ausgesetzt waren. Dieses Verfahren ist im Rahmen der Halbleiter- und Dünnschichttechnologie bei Tantal, Tantal-Kobalt und Wolfram/Kupfer einsetzbar; der erreichte spezifische elektrische Widerstand liegt nach der Kristallisation über 15 µm Ω cm.

Aufgabe der vorliegenden Erfindung ist es, in der Halbleiter- und Dünnschichttechnologie einsetzbare metallische Schichten zu erzeugen, welche auch nach Dauerbelastung ihre elektrischen Eigenschaften nicht mehr ändern, d.h. elektrisch und thermisch stabil sind.

Diese Aufgabe wird erfindungsgemäss dadurch gelöst, dass die thermische Belastung der Metallschicht durch einen Stromimpuls erfolgt, dessen Impulsdauer so kurz gewählt wird, dass sich das Substrat nicht über eine vorgegebene Temperatur erwärmt. Durch den Stromimpuls wird das Material, welches bei seiner Abscheidung mit einer möglichst hohen Dichte an Gitterfehlern vorliegt, über seine Kristallisations- bzw. Rekristallisationstemperatur kurzzeitig erwärmt, wobei aufgrund der wesentlich höheren Wärmekapazität des Substrates dieses sich nicht über z.B. 150° C erwärmt.

Aus der DE-A Nr. 1465701 ist ein Verfahren zur Herstellung eines thermisch und elektrisch stabilisierten Widerstandselements bekannt, bei dem eine niedergeschlagene Metallschicht einer thermischen Belastung durch Stromimpulse ausgesetzt wird. Die Stromimpulse dienen dem Abgleich des Widerstandselements, ihre Dauer liegt im Bereich von Millisekunden.

Bei besonderen Ausführungsarten der Erfindung liegen die Stromdichten im Bereich von $10^5$ bis $10^9$ A/cm² und die Impulsdauer zwischen 0,01 bis 20 s.

Zur Erzielung einer möglichst hohen Dichte an Gitterfehlern wird das Abscheiden bei tieferen Temperaturen, vorzugsweise bei Temperaturen unterhalb −90° C vorgenommen.

Es liegt auch im Rahmen einer weiteren Ausführungsform der Erfindung, den Stromimpuls so oft zu wiederholen, bis der Widerstand der Metallschicht nicht mehr weiter sinkt.

Der Vorteil des erfindungsgemässen Verfahrens liegt darin, dass nur das zu alternde Material auf eine Temperatur erhitzt wird, die wesentlich höher ist als die spätere Betriebstemperatur. Das Substrat erfährt dabei nur eine unbedeutende Erwärmung. Die kurze Zeit bewirkt, dass sich keine dickeren und damit störenden Reaktions- bzw. Diffusionsschichten mit den angrenzenden Materialien bilden.

Ein weiterer Vorzug ist, dass gerade an Stellen mit höherem Widerstand, z.B. an Verengungen, Stufen oder Materialinhomogenitäten mehr Wärme frei wird, so dass an diesen Stellen sich grössere Kristallite bilden können, die sich durch einen etwas geringeren spezifischen elektrischen Widerstand auszeichnen und dadurch der Bildung von *hot spots* vorbeugen. Ist das Kristallgitter extrem stark gestört bzw. sogar amorph, so lassen sich bei bestimmten Materialien (z.B. Aluminium-Kupfer mit 1 bis 15% Atomzahlanteil Aluminium) einkristalline Schichten herstellen.

Da bei dem erfindungsgemässen Verfahren die Energie durch Elektronenstoss direkt auf das Kristallgitter übertragen wird, können auch sehr schnell ablaufende Kristallisationsprozesse, wie z.B. martensitische Umwandlungen, gezielt ausgelöst werden.

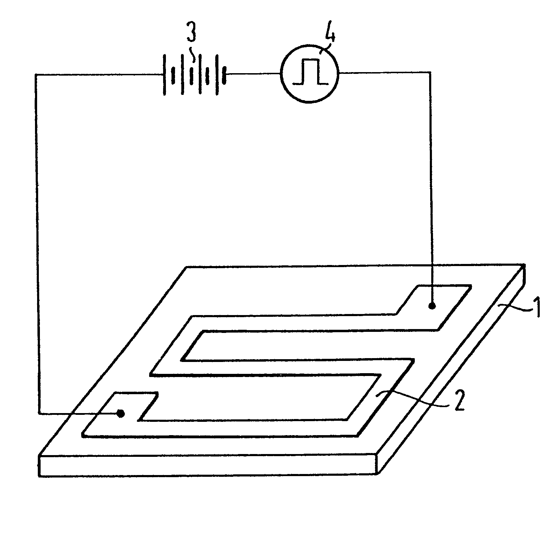

Im folgenden wird die Erfindung anhand eines Ausführungsbeispiels und der in der Zeichnung befindlichen Figur noch näher erläutert.

In der Figur wird eine auf einem Substrat 1 aus Silizium mit einer das Silizium bedeckenden SiO₂-Schicht bei Temperaturen von −160° C in Ultrahochvakuum aufgedampfte metallische Leiterbahn 2 aus einer Aluminium/Kupfer-Legierung mit 6 bis 12 At% Al mit einem Stromimpuls von $10^7$ A/cm² kurzzeitig (5 s) belastet und in eine einkristalline Schicht übergeführt. Der Stromimpuls wird erzeugt durch die Spannungsquelle 3, die von einem Impulsgenerator 4 gesteuert wird.

Das Verfahren nach der Lehre der Erfindung ist anwendbar für alle Metalle und Legierungen, insbesondere für die Metalle Chrom, Tantal, Aluminium, Kupfer, Molybdän, Silber und die Legierungen Aluminium/Kupfer, Kupfer/Nickel, Silber/Gold, Silber/Palladium, Gold/Kupfer, Gold/Palladium und Chrom/Molybdän.

Die dabei erzielten elektrischen Widerstände liegen nach der Kristallisation in den genannten Systemen unterhalb 15 µΩ cm. Im Falle der oben genannten Aluminium/Kupfer-Legierung wurden spezifische elektrische Widerstände von kleiner 12,8 µΩ cm erreicht. Für reine Aluminiumschichten konnten sogar Werte von 4 µΩ cm eingestellt werden. Die Dauer der Stromimpulse lag bei einmal 10 s bzw. zweimal 5 s (Stromdichte $10^7$ A/cm²).

## Patentansprüche

1. Verfahren zum Herstellen von thermisch und elektrisch stabilen, metallischen Schichten auf Substraten, wie sie insbesondere in der Halbleiter- und Dünnschichttechnologie Anwendung finden, bei dem die Metallschichten bei höchstens Raumtemperatur auf den Substraten niedergeschlagen werden und im Anschluss daran oder nach Fertigstellung der Bauelement-Struktur einer thermischen Belastung oberhalb ihrer Kristallisations- bzw. Rekristallisationstemperatur ausgesetzt werden, dadurch gekennzeichnet, dass die thermische Belastung der Metallschicht durch einen Stromimpuls erfolgt, dessen Impulsdauer so kurz gewählt wird, dass sich das Substrat nicht über eine vorgegebene Temperatur erwärmt.

2. Verfahren nach Anspruch 1, dadurch gekennzeichnet, dass während der Abscheidung das Substrat auf Temperaturen unterhalb −90° C gehalten wird.

3. Verfahren nach Anspruch 1 und/oder 2, dadurch gekennzeichnet, dass die Stromdichten im Bereich von $10^5$ bis $10^9$ A/cm² und die Impulszeiten zwischen 0,01 bis 20 s eingestellt werden.

4. Verfahren nach mindestens einem der Ansprüche 1 bis 3, dadurch gekennzeichnet, dass der Stromimpuls so oft wiederholt wird, bis der Widerstand der Metallschicht nicht mehr weiter sinkt.

5. Verfahren nach mindestens einem der Ansprüche 1 bis 4, dadurch gekennzeichnet, dass die Stromimpulse durch einen eine Spannungsquelle steuernden Impulsgenerator erzeugt werden.

6. Verfahren nach Ansprüchen 1 bis 4, gekennzeichnet durch die Verwendung der Metall Chrom, Tantal, Aluminium, Kupfer, Molybdän, Silber und der Legierungen Aluminium/Kupfer, Kupfer/Nikkel, Silber/Gold, Silber/Palladium, Gold/Kupfer, Gold/Palladium, Chrom/Molybdän.

## Revendications

1. Procédé de préparation de couches métalliques stables thermiquement et électroniquement sur des substrats, comme on en utilise notamment dans la technologie des semi-conducteurs et à couche mince, qui consiste à déposer les couches métalliques sur les substrats au plus à la température ambiante et, ensuite ou après achèvement de la structure du composant, à les soumettre à une charge thermique, au-dessus de leur point de cristallisation ou de recristallisation, caractérisé en ce qu'il consiste à effectuer la charge thermique de la couche métallique par une impulsion de courant électrique, dont la durée est choisie si courte que le substrat n'est pas échauffé au-dessus d'une température prescrite.

2. Procédé suivant la revendication 1, caractérisé en ce qu'il consiste à maintenir le substrat à des températures inférieures à −90° C pendant le dépôt.

3. Procédé suivant la revendication 1 (et/ou 2), caractérisé en ce qu'il consiste à régler les densités du courant électrique entre $10^5$ et $10^9$ A/cm² et les durées d'impulsions entre 0,01 et 20 s.

4. Procédé suivant l'une au moins des revendications 1 à 3, caractérisé en ce qu'il consiste à répéter l'impulsion de courant électrique aussi souvent qu'il est nécessaire pour que la résistance de la couche métallique ne diminue plus.

5. Procédé suivant l'une au moins des revendications 1 à 4, caractérisé en ce qu'il consiste à créer les impulsions de courant électrique par un générateur d'impulsions commandé par une source de tension.

6. Procédé suivant les revendications 1 à 4, caractérisé par l'utilisation des métaux chrome, tantale, aluminium, cuivre, molybdène, argent et des alliages aluminium/cuivre, cuivre/nickel, argent/or, argent/palladium, or/cuivre, or/palladium, chrome/molybdène.

## Claims

1. A process for the production of thermally and electrically stable metal layers on substrates, such as are used in particular in semi-conductor and thin layer technology, in which the metal layers are deposited on the substrates at the highest at room temperature and thereafter, or after the finisching of the component structure, are subject to a thermal loading above their crystallization temperature or recrystallization temperature, as the case may be characterized in that the thermal loading of the metal layer is effected by a current pulse, the duration of which is selected to be so short that the substrate is not heated above a given temperature.

2. A process as claimed in claim 1, characterized in that during the deposition the substrate is maintained at temperature below −90° C.

3. A process as claimed in claim 1 and/or 2, characterized in that the current densities are set in the range of $10^5$ to $10^9$ A/cm² and the pulse times are set at from 0.01 to 20 s.

4. A process as claimed in at least one of claims 1 to 3, characterized in that the current pulse is repeated until the resistance of the metal layer does not fall any further.

5. A process as claimed in at least one of claims 1 to 4, characterized in that the current pulses are produced by a pulse generator which controls a voltage source.

6. A process as claimed in claims 1 to 4, characterized by the use of the metals chromium, tantalum, aluminium, copper, molybdenum, and silver, and of the alloys aluminium/copper, copper/nickel, silver/gold, silver/palladium, gold/copper, gold/palladium, and chromium/molybdenum.